## Europäisches Patentamt

(19) **European Patent Office**

**Office européen des brevets**

(11) Veröffentlichungsnummer: **0 250 933 B1**

(12) **EUROPÄISCHE PATENTSCHRIFT**

(45) Veröffentlichungstag der Patentschrift: **11.12.91**

(51) Int. Cl.⁵: $H03K \ 3/356$

(21) Anmeldenummer: **87108192.3**

(22) Anmeldetag: **05.06.87**

(54) **Abtasttaktgesteuerte Schwellwertschaltung in C-MOS-Technik.**

(30) Priorität: **24.06.86 DE 3621047**

(43) Veröffentlichungstag der Anmeldung:
**07.01.88 Patentblatt 88/01**

(45) Bekanntmachung des Hinweises auf die
Patenterteilung:
**11.12.91 Patentblatt 91/50**

(84) Benannte Vertragsstaaten:
**AT BE CH DE FR GB IT LI NL SE**

(56) Entgegenhaltungen:
**EP-A- 0 076 733**
**EP-A- 0 101 571**
**GB-A- 2 018 076**

**IEEE 1985 CUSTOM INTEGRATED CIRCUITS
CONFERENCE, Juni 1985, Seiten 174-177,
IEEE, New York, US; D.B. RIBNER et al.: "80
MHz low offset CMOS fully differential and
single-ended op amps"**

**PATENT ABSTRACTS OF JAPAN, Band 9, Nr.
197 (E-335)[1920], 14. August 1985; & JP-A-60
64 520**

(73) Patentinhaber: **SIEMENS AKTIENGESELL-
SCHAFT**
**Wittelsbacherplatz 2**
**W-8000 München 2(DE)**

(72) Erfinder: **Lang, Thomas, Dipl.-Ing.**
**Schlesierstrasse 3**
**W-8028 Taufkirchen(DE)**

## Beschreibung

Die vorliegende Erfindung betrifft eine abtasttaktgesteuerte Schwellwertschaltung in C-MOS-Technik.

In der Technik integrierter Schaltungen hat man verschiedene Schaltungstechnologien entwickelt, die jeweils bestimmten, an integrierte Schaltungen zu stellende Anforderungen in besonderem Maße gerecht werden, dabei aber in der Regel auch mit weniger vorteilhaften anderen Eigenschaften behaftet sind. So läßt sich etwa die sog. Silizium-Bipolar-Technik durch Eigenschaften wie hohe Arbeitsgeschwindigkeit, (mittel-)hoher Integrationsgrad und (mittel)hohe Verlustleistung charakterisieren; die sog. C-MOS-Technik zeichnet sich - bei demgegenüber allerdings nur mittleren Arbeitsgeschwindigkeiten - durch einen sehr hohen Integrationsgrad und sehr niedrige Verlustleistungen aus. Diese letzteren Eigenschaften führen zu dem Bemühen, mit integrierten Schaltungen in C-MOS-Technik auch in bislang der Bipolar-Technik vorbehaltene Geschwindigkeitsbereiche vorzudringen. Diese Tendenz findet sich insbesondere in der modernen Übertragungs- und Vermittlungstechnik, wobei sich nicht nur Aufgaben der reinen Digtialsignalverarbeitung stellen, sondern es in einem sog. Entscheider auch erforderlich wird, Analogsignale schnell verarbeiten zu können. Für einen solchen Entscheider, der in jedem Entscheidungszeitpunkt festzustellen hat, ob eine Signalamplitude einen Schwellwert überschreitet oder nicht, stellt sich die Forderung nach hoher Zeitauflösung, d. h. Kurzer Entscheidungszeit, und hoher Amplitudenauflösung, d. H. niedriger Schwellenunsicherheit, wobei man vor einem gegenläufigen Optimierungsproblem steht.

C-MOS-Entscheiderschaltungen mit relativ hoher Schwellensicherheit sind aus dem Bereich der Analog-/Digital-Wandler bekannt. Dort erreichen nichttaktgesteuerte Versionen (übersteuerte Differenzverstärker) maximale Abtastfrequenzen von bis zu 10 MHz (INT. J. ELECTRONICS, 1984, Vol. 57, No. 2, 195...198); taktgesteuerte Entscheider in vollparallel arbeitenden (sog. Flash-)Analog/Digital-Wandlern können Abtastraten von 20 bis 25 MHz haben (Electronic Design: August 19, 1982, 37...38; October 31, 1984, 230; May 2, 1985, 54; 1985 IEEE Int. Solid-State Circuits Conf. Papers, 34...35; NEC Res. & Develop., No. 78, July 1985, 91...95). Bei Bitraten in der Größenordnung von 140 Mbit/s und einer geforderten Schwellenunsicherheit etwa von ± 10 mV war man indessen bislang auf die bipolare (ECL-)Technik angewiesen (siehe auch NTG-Fachbericht "Großintegration" März 1985, 53...57), was dann einer monolitischen Integration in C-MOS-Technik entgegensteht.

Es ist auch (aus EP-A-0 076 733) eine in drei Taktphasen taktgesteuerte C-MOS-Eingangsschaltung für TTL-Signale mit zwei kreuzgekoppelten C-MOS-Inverterschaltungen bekannt, in der in einer Vorlade-Taktphase die beiden dabei von ihren Betriebpotentialquellen getrennten (und so als Inverter unwirksam geschalteten) Inverterschaltungen über zwei n-Kanal-Transistoren auf Masse-Potential geladen werden, in der danach in einer Abtast-Taktphase die dabei weiterhin von ihren Betriebspotentialquellen getrennte eine C-MOS-Inverterschaltung auf das Eingangssignal-Potential und die dabei ebenfalls von ihren Betriebspotentialquellen getrennte andere C-MOS-Inverterschaltung auf ein Referenz-Potential aufgeladen wird und in der danach in einer Bewertungs-Taktphase die beiden C-MOS-Inverterschaltungen an ihre Betriebspotentialquellen angeschaltet und damit als Inverter wirksamgeschaltet werden.

Eine solche - an sich eine abtasttaktgesteuerte Schwellwertschaltung mit einer Ringschaltung zweier C-MOS-Inverter mit zwei jeweils einen Differenzsignal-Aus- und Eingang der Schwellwertschaltung bildenden, jeweils zwischen dem Ausgang eines C-MOS-Inverters und dem Eingang des jeweils anderen C-MOS-Inverters liegenden Schaltungspunkten bildende, - drei Taktphasen erfordernde C-MOS-Eingangsschaltung mit in der Vorlade-Taktphase auf Masse-Potential festgehaltenen und damit von einer nur geringen Steilheit ihrer n-Kanal-Transistoren ausgehenden C-MOS-Inverterschaltungen hat ebenfalls nur eine relativ geringe Arbeitsgeschwindigkeit.

Die Erfindung zeigt nun einen Weg zu einer in C-MOS-Technik gehaltenen Schwellwertschaltung, die sich sowohl durch eine hohe Arbeitsgeschwindigkeit (Zeitauflösung) als auch durch eine hohe Amplitudenauflösung auszeichnet.

Die Erfindung betrifft eine abtasttaktgesteuerte Schwellwertschaltung bzw. Entscheider in C-MOS-Technik mit einer Ringschaltung zweier C-MOS-Inverter mit zwei jeweils einen Differenzsignal-Aus- und Eingang der Schwellwertschaltung bildenden, zwischen dem Ausgang eines C-MOS-Inverters und dem Eingang des jeweils anderen C-MOS-Inverters liegenden Schaltungspunkten; diese Schwellwertschaltung ist erfindungsgemäß dadurch gekennzeichnet, daß die zwei jeweils einen Differenzsignal-Aus- und Eingang bildenden Schaltungspunkte durch einen mit dem Abtasttakt gesteuerten n-Kanal-Transistor-Schalter in jeder Abtasttaktpause miteinander kurzgeschlossen sind.

Es sei an dieser Stelle bemerkt, daß es (aus EP-A-0 101 571) bekannt ist, bei einem taktgesteuerten Differenzspannungsverstärker mit einem über einen Kondensator abwechselnd mit einer Referenzspannung und einer Signalspannung angesteuerten einfachen Inverter an diesen Inverter in der Referenzspannungs-Phase einen kurzgeschlossenen weiteren Inverter gleicher Charakteristik anzuschalten, so daß die Inverter-Schwellenspannung an der Eingangsklemme des erstgenannten Inverters wirksam wird. Dieser Differenzspannungsverstärker weist keinerlei Mitkopplungsstruktur auf; auch sonst sind keine näheren Berührungspunkte zur vorliegenden Erfindung gegeben.

Die Erfindung, die sich das Prinzip einer Mitkopplung jeweils aus einer quasi-stabilen Auto-Zero-Phase (mit der Eigenschaft Eingangsspannung gleich Ausgangsspannung) heraus zunutze macht und dabei mit einfachen Inverterstrukturen auskommt, bringt eine Reihe von Vorteilen mit sich: Die verfügbare Betriebsspannung wird jeweils auf nur zwei Transistoren (p-Kanal-Transistor und n-Kanal-Transistor des C-MOS-Inverters) aufgeteilt und ermöglicht daher in den Abtasttaktpausen (Reset-Phase) einen (einfach einzustellenden) Arbeitspunkt mit hoher Steilheit für die Startphase des Entscheiders.

Dieser Arbeitspunkt liegt unter der Bedingung Eingangsspannung gleich Ausgangsspannung etwa bei der halben Betriebsspannung, so daß sich gegenüber konventionellen C-MOS-Schaltungen wegen des reduzierten Pegelhubs die Einschwingzeit verkürzt.

Bei Einhaltung bekannter Designregeln entspricht dieser Arbeitspunkt sehr genau den Schaltpunkten der geometrisch benachbarten Logikschaltungen mit entsprechender Geometrie und führt dadurch zu einer gesteigerten Unabhängigkeit von Technologieschwankungen.

Die dynamisch wirksamen Kapazitäten sind dabei dadurch, daß beide Transistorkanäle in den Abtasttaktpausen leitend sind, merklich geringer als in C-MOS-Standardschaltungen mit nicht stromführenden Transistoren.

Ohnehin bringt die im Vergleich zu in der Analogschaltungstechnik sonst üblichen Differenzverstärkerstrukturen mit Stromquellen (s. INT. J. ELECTRONICS, a.a.O.) Geringere Anzahl von Schaltelementen eine Reduzierung der an den signalführenden Schaltungsknoten wirksamen Lastkapazitäten mit sich.

Vermieden werden schliesslich in bekannten taktgesteuerten Entscheidern (s. Electronic Design, a.a.O.) Erforderliche Kondensatoren, die integriert nur schwer, in einem relativ aufwendigen Herstellungsprozess, zu realisieren wären.

Es sei an dieser Stelle bemerkt, daß (aus GB-A-2 018 076) ein abtastgesteuerter C-MOS-Speicherabtastverstärker mit zwei kreuzgekoppelten p-Kanal-Transistoren, die jeweils mit einem an einer Speicherausgangsleitung liegenden n-Kanal-Lasttransistor verbunden sind, bekannt ist, bei dem in einer Vorphase die Ausgänge der beiden Transistorschaltungen miteinander verbunden werden und zugleich beide Transistorschaltungen von der negativen Betriebspotentialquelle (Masse) abgetrennt werden, um damit einen Stromfluß zu vermeiden. Die Erfindung sieht demgegenüber eine abtasttaktgesteuerte Schwellwertschaltung mit einer Ringschaltung zweier C-MOS-Inverter vor, in der es nicht un die Vermeidung eines Stromflusses geht, sondern darum, ungeachtet der Frage eines solchen Stromflusses in den Abtastpausen einen (einfach einzustellenden) Arbeitspunkt hoher Steilheit zu ermöglichen.

Weitere Besonderheiten der Erfindung werden aus der nachfolgenden näheren Erläuterung der Erfindung anhand der Zeichnung ersichtlich.

In der Zeichnung ist ein Ausführungsbeispiel einer in C-MOS-Technik gehaltenen, abtasttaktgesteuerten Schwellwertschaltung (Entscheider) gemäß der Erfindung dargestellt. Diese C-MOS-Schwellwertschaltung weist zwei jeweils mit einem p-Kanal-Transistor Tp' bzw. TP″ und einem n-Kanal-Transistor Tn' bzw. Tn″ gebildete C-MOS-Inverter J′,J″ auf, deren zwei jeweils einen Differenzsignal-Aus- und Eingang der Schwellwertschaltung bildende Schaltungspunkte Q und $\overline{Q}$, die zwischen dem Ausgang jeweils eines C-MOS-Inverters J″ bzw. J′ und dem Eingang des jeweils anderen C-MOS-Inverters J′ bzw.J″ liegen, durch einen über eine Taktleitung t abtasttaktgesteuerten n-Kanal-Transistor-Schalter S in den Abtasttaktpausen mit einer beide C-MOS-Inverter J′,J″ auf gleichen Arbeitspunkten festhaltenden Referenzspannungsquelle verbunden sind. Diese Referenzspannungsquelle kann durch einen - zumindest in den Abtastpausen - kurzgeschlossenen C-MOS-Inverter gebildet sein; in dem in der Zeichnung skizzierten Ausführungsbeispiel wird hierfür der jeweils andere C-MOS-Inverter J′ bzw. J″ mitausgenutzt:

Die zwei jeweils einen Differenzsignal-Aus- und Eingang der Schwellwertschaltung bildenden, jeweils zwischen dem Ausgang eines C-MOS-Inverters J′ bzw. J″ und dem Eingang des jeweils anderen C-MOS-Inverters J″ bzw. J′ liegenden Schaltungspunkte $\overline{Q}$ und Q sind durch den mit dem Abtasttakt gesteuerten n-Kanal-MOS-Transistor-Schalter S in den Abtasttaktpausen miteinander kurzgeschlossen.

Der in der Zeichnung skizzierte Entscheider arbeitet dann wie folgt.

In einer Abtasttaktpause sind, wie gesagt, die beiden Schaltungspunkte Q und $\overline{Q}$ über den leitenden n-Kanal-Transistor-Schalter S miteinander kurzgeschlossen. In diesem Betriebszustand stellt sich der Entscheider als Parallelschaltung zweier zwischen dem Betriebspotential $V_{CC}$ und Masse liegender Spannungsteiler Tp′-Tn′ bzw. Tp″-Tn″ dar, die an ihrem jeweiligen Angriffspunkt $\overline{Q}$ bzw. Q jeweils das gleiche Potential aufweisen, das C-MOS-spezifisch im Bereich des halben Speisepotentials $V_{CC}$ liegt.

Die Eingangsspannung des Entscheiders ist gleich der Ausgangsspannung.

Wird mit Beendigung der Abtasttaktpause der n-Kanal-Transistor-Schalter S nichtleitend, so wird aus dem Spannungsteiler eine mitgekoppelte Flip-Flop-Struktur der beiden C-MOS-Inverter J', J", die sich in einem labilen Gleichgewichtszustand befindet. Eine Störung dieses Zustandes durch ein an den Schaltungspunkten Q, $\overline{Q}$ auftretendes Differenzsignal schaukelt sich in der Ringschaltung der beiden C-MOS-Inverter J', J" bis zu einer Selbstbegrenzung auf, und der damit erreichte stabile Zustand des Entscheiders dauert so lange an, bis der n-Kanal-Transistor-Schalter S mit Beginn der nächstfolgenden Abtasttaktpause wieder leitend wird, woraufhin der Entscheider wieder in seinen zuerst beschriebenen quasi-stabilen Ausgangszustand zurückkehrt.

In der Zeichnung ist angedeutet, daß dem Entscheider ein Eingangssignal von einer Differenzverstärkerschaltung D her zugeführt werden kann, die, um eine monolithische Integration zu ermöglichen, ebenfalls in C-MOS-Technik gehalten sein möge.

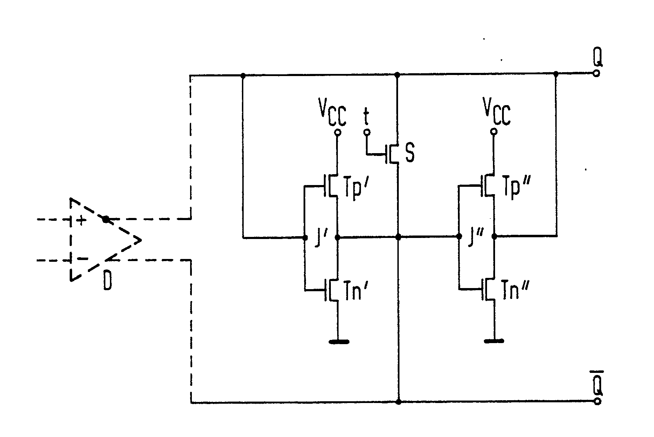

Diese Differenzverstärkerschaltung kann vorzugsweise eine mit einem p-(oder n-)Kanal-Transistoren in Source-Schaltung aufweisenden Eingangs-Differenzverstärker und einem n-(bzw. p-)Kanal-Transistoren in Gate-Schaltung aufweisenden Ausgangs-Differenzverstärker aufgebaute sog. gefaltete Differenzkaskodeschaltung (siehe z.B. IEEE 1985 Custom Integrated Circuits Conference Papers, 174...176, Fig. 1, linke Schaltungshälfte) sein; bei einer solchen gefalteten Differenzkaskodeschaltung liegt im Ruhezustnd der - mit dem Eingangssignalpegel übereinstimmende - Ausgangssignalpegel im Bereich des halben Betriebspotentials.

Eine solche in C-MOS-Technik gehaltene Differenzverstärkerschaltung D unterliegt hinsichtlich ihrer Arbeitsgeschwindigkeit den für die C-MOS-Technik an sich gegebenen Begrenzungen; solche Begrenzungen der Arbeitsgeschwindigkeit werden indessen durch die Entscheiderschaltung gemäß der Erfindung überwunden:
Bevor sich auf einen neuen Eingangssignalpegel hin die Differenzverstärkerschaltung D auf den entsprechenden Ausgangszustand mit vollem Pegelhub eingeschwungen haben würde, bewirkt der weitgehend technologieunabhängig gerade im Schaltpunkt einer nachfolgenden C-MOS-Schaltung mit dem Entscheidungsvorgang startende Entscheider J', J" ein beschleunigtes Einschwingen bzw. Umkippen auf den neuen Signalendwert. Die Differenzverstärkerschaltung D kann daher ggf. sogar noch als Integrator sinnvoll betrieben werden; wesentlich ist nur, daß zum Startzeitpunkt des Entscheidungsvorganges, d.h. am Ende der vorangehenden Abtasttaktpause, das Entscheidereingangssignal sich an den beiden Schaltungsknoten Q und $\overline{Q}$ hinreichend als Störung des labilen Gleichgewichts des Entscheiders aufintegriert hat. Die Entscheiderschaltung gemäß der Erfindung, bei der die beiden das Komplementärsignal führenden Leitungen (Q und $\overline{Q}$) zwischen Ein- und Ausgang nicht unterbrochen sind, die vielmehr nur das Einschwingen auf den Signalendwert abrupt beschleunigt, ermöglicht so mit C-MOS-Technologien, deren effektiven Kanallängen etwa bei 1,4 $\mu$m liegen, eine sichere Amplitudenentscheidung bei Abtasttaktfrequenzen, die bis über 200 MHz reichen können.

## Patentansprüche

1. Abtasttaktgesteuerte Schwellwertschaltung bzw. Entscheider in C-MOS-Technik, mit einer Ringschaltung zweier C-MOS-Inverter (J', J") mit zwei jeweils einen Differenzsignal-Aus- und Eingang der Schwellwertschaltung bildenden, jeweils zwischen dem Ausgang eines C-MOS-Inverters (J' bzw. J") und dem Eingang des jeweils anderen C-MOS-Inverters (J" bzw.J') liegenden Schaltungspunkten (Q und $\overline{Q}$), **dadurch gekennzeichnet,** daß die zwei jeweils einen Differenzsignal-Aus- und Eingang bildenden Schaltungspunkte (Q und $\overline{Q}$) durch einen mit dem Abtasttakt gesteuerten n-Kanal-Transistor-Schalter (S) in jeder Abtasttaktpause miteinander kurzgeschlossen sind.

2. Schwellwertschaltung bzw. Entscheider nach Anspruch 1, **dadurch gekennzeichnet,** daß die zwei jeweils einen Differenzsignal-Aus- und Eingang bildenden Schaltungspunkte (Q und $\overline{Q}$) mit den Differenzsignal-Ausgangsklemmen einer gefalteten Differenzkaskodeschaltung (D) verbunden sind.

## Claims

1. Scanning clock-controlled C-MOS technique threshold circuit or decision circuit, having a ring circuit of two C-MOS invertors (J', J") having two circuit points (Q and $\overline{Q}$), in each case forming a differential signal output and input of the threshold circuit and in each case located between the output of a C-MOS invertor (J' or J") and the input of the other C-MOS invertor (J" or J') respectively, characterized in that the two circuit points (Q and $\overline{Q}$), in each case forming a differential signal output and input, are short-circuited to each other in each scanning clock pulse space by an n-channel transistor switch (S), controlled by the scanning clock.

2. Threshold circuit or decision circuit according to Claim 1, characterized in that the two circuit points (Q and $\overline{Q}$), in each case forming a differential signal output and input, are connected to the differential signal output terminals of a folded differential cascode circuit (D).

**Revendications**

1. Circuit à valeur de seuil ou discriminateur commandé par une cadence d'échantillonnage et réalisé selon la technique C-MOS, et comportant un circuit en anneau formé de deux inverseurs C-MOS (J',J") et comprenant deux points (Q et $\overline{Q}$) constituant respectivement une sortie et une entrée du signal de différence du circuit à valeur de seuil et situés respectivement entre la sortie d'un inverseur C-MOS (J' ou J") et l'entrée de l'autre inverseur C-MOS respectif (J" ou J'), caractérisé par le fait que les deux points (Q et $\overline{Q}$) du circuit, qui constituent respectivement une sortie et une entrée du signal de différence, sont court-circuités l'une l'autre par un interrupteur (S) à transistor à canal n, commandé par la cadence d'échantillonnage, pendant chaque pause de cette cadence.

2. Circuit à valeur de seuil ou discriminateur suivant la revendication 1, caractérisé par le fait que les deux points (Q et $\overline{Q}$) du circuit, qui constituent respectivement une sortie et une entrée du signal de différence, sont raccordés aux bornes de sortie du signal de différence d'un circuit cascade différentiel replié (D).